(19) **Europäisches Patentamt / European Patent Office / Office européen des brevets**

(11) **EP 1 833 063 A1**

(12) **EUROPEAN PATENT APPLICATION**
published in accordance with Art. 158(3) EPC

(43) Date of publication:
**12.09.2007 Bulletin 2007/37**

(51) Int Cl.:
*H01F 27/255* (2006.01)   *H01F 27/28* (2006.01)
*H01F 30/00* (2006.01)   *H01F 37/00* (2006.01)

(21) Application number: **05809497.0**

(22) Date of filing: **22.11.2005**

(86) International application number:
**PCT/JP2005/021465**

(87) International publication number:
**WO 2006/070544 (06.07.2006 Gazette 2006/27)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **27.12.2004 JP 2004377718**

(71) Applicant: **Sumida Corporation Tokyo 103-8589 (JP)**

(72) Inventors:
• **SANO, Kan,**
  **Sumida Electric Co., Ltd**
  **Tokyo 103-8589 (JP)**
• **YAMADA, Satoru,**
  **Sumida Electric Co., Ltd**
  **Tokyo 103-8589 (JP)**

(74) Representative: **Schäfer, Matthias W.**
  **Patentanwalt**
  **Schwanseestrasse 43**
  **81549 München (DE)**

(54) **MAGNETIC DEVICE**

(57) Disclosed is a small-sized magnetic device (10) having a reduced inductance which can be manufactured easily. This magnetic device (10) comprises a core member (20) which is formed by press molding a mixture of a magnetic powder containing a metal and a resin binder. A straight conductor (30) is placed inside the core member (20). The magnetic device (10) further comprises a terminal electrode (40) which is arranged on the outer surface (21) of the core member (20) and electrically connected to the conductor (30). The terminal electrode (40) is also electrically connected to a mount board when the magnetic device is mounted thereto.

FIG.1

EP 1 833 063 A1

**Description**

Technical Field

The present invention relates to a magnetic device used for, for example, a power supply circuit of various electric appliances.

Background Art

In the magnetic devices used for a power source, a switching frequency of a driving circuit gradually shifts to a high frequency side. Here, the relation described below is established between frequency f, current I, an inductance value (L value) of a magnetic device and power P of the magnetic device.

$$P = 1/2 \times L \times I^2 \times f \text{ (equation 1)}$$

Considering on the basis of this equation 1, when the power P is constant, as the frequency f increases, the L decreases. Therefore, in recent years, along with the shift of the switching frequency to the high frequency side and so forth, there are large demands such as for reducing the L value of the magnetic device (hereinafter, abbreviated and called the "L reduction") and for allowing larger current to be applied.

Here, in order to boost the L reduction and to respond to the large current application, resistance of a wiring (conductor) needs to be reduced to lower. Further, it is required to select the material, structure and manufacturing conditions to prevent the inductance reduction caused by magnetic saturation when the large current is applied. In addition, along with the downsizing in electronic equipment in recent years, the magnetic devices are required to be downsized as well. Furthermore, it is required that the magnetic device can be manufactured easily and that the manufacturing cost is reduced to lower.

Here, the magnetic device generally includes a coil section in which a wiring is wound predetermined times so as to obtain a desired inductance value (L value). Then, the above-described coil section is coated by a magnetic material or the like and further both the ends of the wiring of the coil section are connected to a terminal electrode, so that a magnetic device mountable on a mounting substrate is formed. Note that, as a typical structural example of the magnetic device as described above, there is one disclosed in Patent document 1.

Further, as a magnetic device having a structure different from that of the magnetic device in Patent document 1, there is known a magnetic device, in which a tubular hole is provided along the longitudinal direction of a polygonal tubular ferrite core, a slit connecting the tubular hole and an under surface of the ferrite core is provided, and a conductor is inserted into the tubular hole. As an above-described magnetic device, there is one disclosed in Patent document 2.

Patent document 1: Japanese Patent Application Laid-Open No. 2002-252120 (see Fig. 1, Fig. 3 to Fig. 5 and so forth)
Patent document 2: Japanese Patent Application Laid-Open No. 2001-052934 (see Fig. 1 to Fig. 7 and so forth)

Disclosure of the Invention

Problems to be Solved by the Invention

According to the structure of the magnetic device in Patent document 1, with the provision of the coil section in which a wiring is wound around only predetermined times, the inductance value obtained increases in general. However, in the structure disclosed in Patent document 1, a DC bias characteristics tends to degrade. Further, due to a resistance value increase caused by an elongated conductor length, a generated heat when applied the larger current possibly leads to a problem. Moreover, since the coil section formed by winding the wiring around an air-core is provided internally and the press-molding is performed to control the thickness of the coating of the magnetic body to be uniform over the respective portions, the manufacturing method becomes complicated.

Further, according to the structure of the magnetic device in Patent document 2, it is possible to achieve the reductions in L value as well as the resistance of the conductor as compared to the magnetic device in Patent document 1, however, the breaking point of the magnetic characteristic and the like is low in general due to the core member, which is formed by the ferrite core having degree of sintering. In addition, in the formation of the slit, a cutting process is required for the sintered core. Hence, an increase in the steps and the like are concerned. Furthermore, the tubular hole of the polygonal tube ferrite core is forced to have a slightly larger size than a conductor having a belt shape so as to facilitate an inserting work of the conductor having the belt shape. Therefore, practically, a space is generated between the conductor and the tubular hole. Accordingly, the conductor generated heat by the current application is put into a state of contacting an air having poor thermal conductivity, in which the conductor stores heat, so that the temperature increases evidently. Therefore, even with a favorable DC bias characteristics, it is impossible to ensure the reliability related to the temperature of the magnetic device.

The present invention has been made based on the above-described circumstances and an object thereof is to provide a magnetic device capable of reducing an inductance value and ensuring a desired inductance value by simple manufacturing conditions, and further, having an excellent DC bias characteristics and capable of ensuring a downsizing and a higher reliability.

Means for Solving the Problems

In order to bring a solution to the above-described problems, the magnetic device according to the present invention includes: a core member formed by press-molding a mixture mixing magnetic powders containing metal and a resin-type binder; a conductor provided inside the core member and extended in a linear manner; a terminal electrode provided on an outer surface of said core member and electrically connected to said conductor as well as a mounting substrate when mounted thereon.

When it is structured in the above-described manner, the conductor is extended in a linear manner inside the core member, in which the conductor is not in a wound state inside the core member. Therefore, the L reduction can be realized in the magnetic device. Hence, the magnetic device can be used even in the circuit to which high frequency current is applied in a power supply system.

Further, the conductor is extended in a linear manner, so that the manufacturing method of the magnetic device is facilitated. Specifically, the conductor being extended in a linear manner is set for example inside a mold, and after that, it is coated with granulated powders and press-molded as it is, so that the magnetic device can be formed easily. Thus, the magnetic device can be formed easily, so that the manufacturing cost of the magnetic device can be reduced as well.

Further, the conductor is extended in a linear manner, so that the magnetic device can be downsized by using a conductor having a plate shape or the like.

Further, another invention is, in addition to the above-described invention, further, the terminal electrode is connected to the conductor continuously and processed to be folded toward the mounting substrate side.

When it is structured in the above-described manner, the conductor and the terminal electrode are structured substantially in a unified manner. Therefore, it is not required to prepare the conductor and the terminal electrode, separately, and that, it is not required to connect the separated conductor and terminal, allowing the facilitation of the manufacturing and the cost reduction.

Further, a still another invention is, in addition to the above, recessed portions for terminal electrodes are provided on a facing surface of the core member facing to the mounting substrate and the recessed portions for terminal electrodes are recessed deeper than the other portion of the facing surface to correspond to the fold portion of said terminal electrode. When it is structured in the above-described manner, the fold portions enter into the recessed portions for terminal. Therefore, the magnetic device can be downsized in height.

Further, a still another invention is, in addition to the above invention, further, an entire outer peripheral surface of said conductor directly adheres to said core member.

When it is structured in the above-described manner, since the magnetic device has effects of absorbing and releasing heat, the temperature increase characteristic of the magnetic device becomes favorable even when the conductor generates heat at the time of the large current application, so that the reliability of the magnetic part is improved as a result thereof. Further, the entire outer peripheral surface of the conductor adheres to the magnetic core directly, in other words, no insulative film having poorer thermal conductivity than the metal material being a base material of the conductor exists therein, so that the heat releasing characteristic can be increased further and the material cost reduction can be achieved as well by eliminating the insulative film.

Further, a still another invention is, in addition to the above-described invention, a plurality of the conductors are provided inside the core member and the respective conductors are arranged to have a certain interval between the adjacent conductor(s).

When it is structured in the above-described manner, it is put into the state where the plurality of conductors are arranged inside the core member. Therefore, the magnetic device as described above can be used as a multiple inductor, a multiple noise filter, a common mode choke, a transformer or the like with Multiphase support for a power supply circuit driven by high frequency, as an example.

Further, a still another invention is, in addition to the above respective inventions, the conductor, the terminal electrode and an outside conductor existing on the mounting substrate form a circuit in which current goes around rounds.

When it is structured in the above-descried manner, the conductor arranged inside the core member, the terminal electrode, and the outside conductor of the mounting substrate on which it is to be mounted form the coil section. Therefore, when the current is conducted, a closed magnetic circuit can be formed, so that it can be used as various coil parts.

Effect of the Invention

According to the present invention, the inductance value of the magnetic device can be reduced, and at the same time, the superior DC bias characteristics can be obtained, so that high reliability can be obtained in the magnetic device at the time of the large current application. Further, the downsizing and the facilitation of manufacturing can be realized in the magnetic device.

Brief Description of Drawings

[Fig. 1] Fig. 1 is a perspective view showing an entire structure of a first structural example of a magnetic device according to a mode of the present invention, in which a state before bending terminal electrodes is shown;

[Fig. 2] Fig. 2 is a sectional front view showing the structure of the magnetic device in Fig. 1;

[Fig. 3] Fig. 3 is a side view showing the structure of the magnetic device in Fig. 1;

[Fig. 4] Fig. 4 is a plan view showing a second structural example of the magnetic device according to the mode of the present invention;

[Fig. 5] Fig. 5 is a bottom view showing the structure of the magnetic device in Fig. 4;

[Fig. 6] Fig. 6 is a sectional side view showing the structure of the magnetic device in Fig. 4 and, at the same time, showing a state cut along a B-B line in Fig. 5;

[Fig. 7] Fig. 7 is a sectional front view showing the structure of the magnetic device in Fig. 4 and, at the same time, showing a state cut along an A-A line in Fig. 5;

[Fig. 8] Fig. 8 is a view showing a relation between current and temperature increase in the first structural example of the magnetic device according to the mode of the present invention and a conventional example of the magnetic device;

[Fig. 9] Fig. 9 is a perspective view showing a structure of a comparative (conventional) magnetic device;

[Fig. 10] Fig. 10 is a front view related to a modification example of the magnetic device of the present invention and showing a state where two conductors are arranged inside a core member;

[Fig. 11] Fig. 11 is a perspective view showing a mode in which the magnetic device in Fig. 4 is mounted onto a mounting substrate; and

[Fig. 12] Figs. 12 are views related to a modification example of the present invention and showing a state where three conductors are arranged inside the core member by sandwiching a nonmagnetic layer between adjacent conductors, in which (a) is a sectional view viewing from a front direction and (b) is a plan view showing a state where the conductors and nonmagnetic layers inside the core member are seen through.

Description of numerical references

| 10, 11, 12 | magnetic device |
| 20 | core member |
| 21 | outside surface |
| 21a | upper surface |
| 21b | end surface |
| 21c | under surface |
| 21e, 21f | side face |
| 22 | nonmagnetic layer |
| 23 | recessed portions for terminal electrodes |
| 30 | conductor |
| 40 | terminal electrode |
| 41 | end surface portion |
| 42 | mounting portion |
| 50 | thin plate member |
| 60 | mounting substrate |

Best Mode for Carrying out the Invention

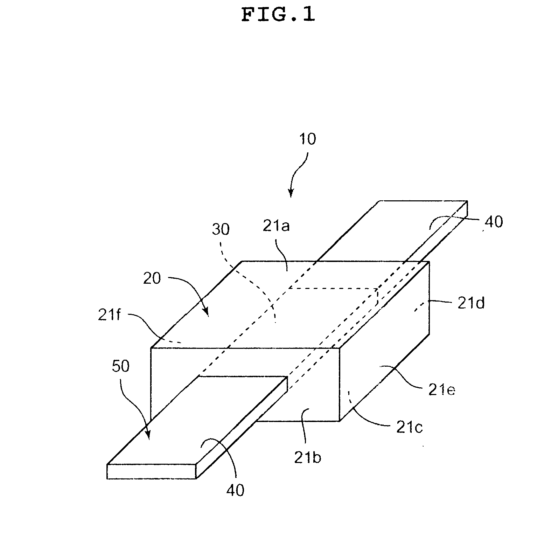

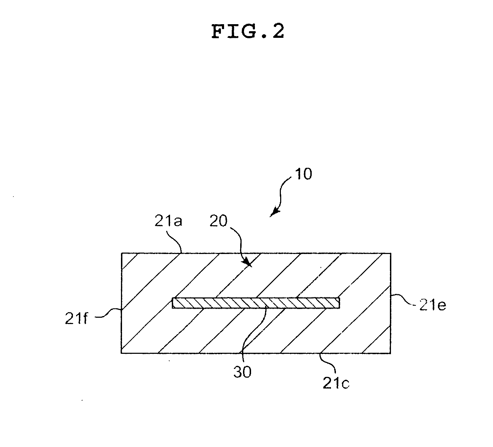

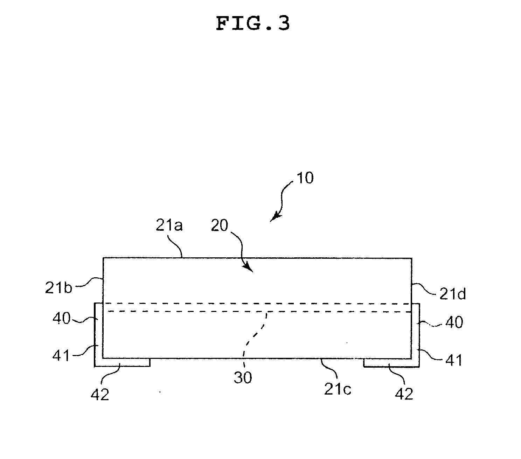

Hereinafter, a magnetic device 10 according to a first mode of the present invention will be described based on Fig. 1 to Fig. 9. Fig. 1 to Fig. 3 are views showing a first structural example of the magnetic device 10 according to the present mode, in which Fig. 1 is a perspective view showing an entire structure of the magnetic device 10 and a state before bending terminal electrodes 40. Also, Fig. 2 is a sectional front view showing the structure of the magnetic device 10. Further, Fig. 3 is a side view showing the structure of the magnetic device 10.

Note that, in the description below, an upper side means an upper surface 21a side of the magnetic device 10 distant from a later-described under surface 21c, and a lower side means the under surface 21c side distant from the upper surface 21 a. Similarly, a height direction means a vertical direction connecting the upper surface 21a and the under surface 21c in the magnetic device 10.

The magnetic device 10 according to the present mode includes a core member 20, a conductor 30 and terminal electrodes 40 as shown in Fig. 1 to Fig. 3. Of these, the core member 20 is formed by a magnetic material. As an example of such a magnetic material, there are a magnetic material containing metal powders mainly composed of Sendust (Fe-Si-Al: iron-silicon-aluminum), Fe-Si-Cr (Iron-silicon-chromium) and Permalloy (Fe-Ni).

Note that, in the present mode, the core member 20 is formed by curing granulated powders mixing the above-described magnetic material, an epoxy resin and an organic solvent.

Further, as shown in Fig. 1, the core member 20 has substantially a rectangular parallelepiped shape in appearance. In more detail, out of six outer surfaces 21 composing the core member 20 of the rectangular parallelepiped shape, the outer surface (in Fig. 1, the outer surface positioned at the upper side and called the "upper surface 21a" in the description below) directly facing a mounting substrate (not shown) and the under surface 21c (corresponding to the facing surface facing the mounting substrate) in parallel therewith are provided to have the largest area among the six outer surfaces 21. Note that, in the description below, the six outer surfaces 21 include end surfaces 21b, 21d from which a pair of terminal electrodes 40 extend, respectively, and side surfaces 21e, 21f being perpendicular to these end surfaces 21b, 21d, the upper surface 21a and the under surface 21c, in addition to the upper surface 21a and the under surface 21c. When describing these plural outer surfaces 21, these upper surface 21a, under surface 21c, end surfaces 21 b, 21d and side surfaces 21e, 21f and the like are also described as the outer surfaces 21 a to 21 f, respectively.

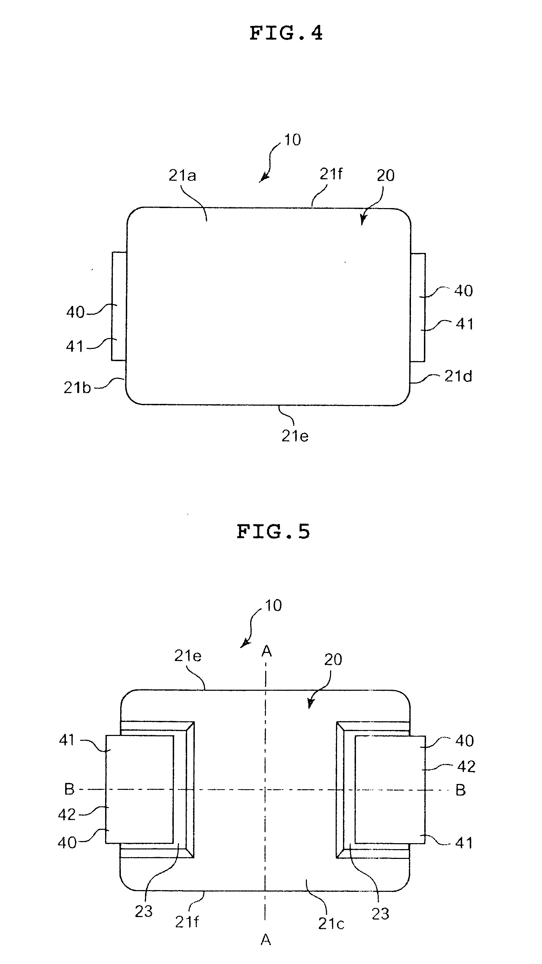

Note that a second structural example of the magnetic device 10 according to the present mode is shown in Fig. 4 to Fig. 7. As shown these Fig. 4 to Fig. 7, in the magnetic device 10 of the second structural example, recessed portions 23 for terminal electrodes are provided in the under surface 21c of the core member 20. These recessed portions 23 for terminal electrodes are are portions into which the fold portions of the terminal electrodes 40, which will be folded as described later, are entered. The recessed portions 23 for terminal electrodes are portions provided to recess upward larger than the other portion of the under surface 21 c. Further, in Fig. 5, the one ends side of the recessed portions 23 for terminal electrodes are provided on the end surfaces 21b, 21d sides, respectively, rather than a center line A-A side along the short hand direction. And that, the other end sides of the recessed portions 23 for terminal electrodes are provided to go through the under surface 21c toward the end surfaces 21b, 21d, respectively. In other words, the end surfaces 21b, 21d and the recessed portions 23 for terminal electrodes are provided in the state of communicating with each other.

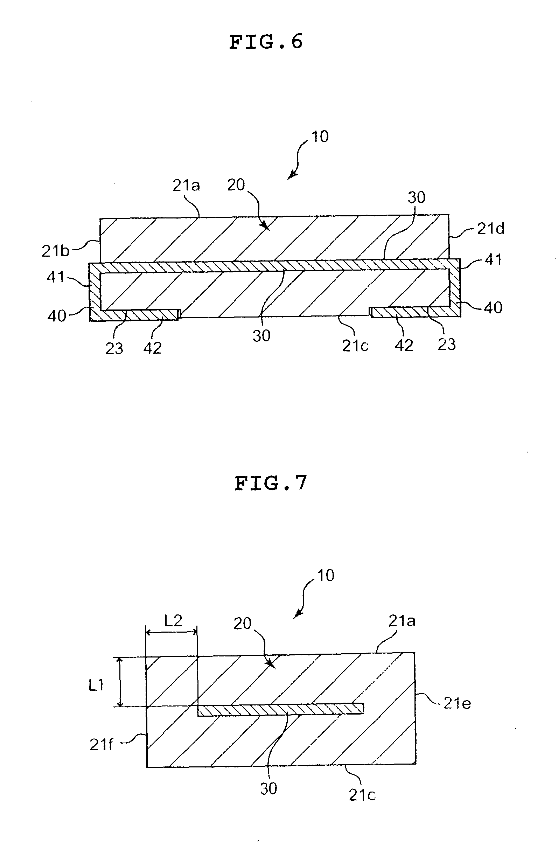

Here, as shown in Fig. 6, a depth d of the above-described recessed portions 23 for terminal electrodes are provided to be smaller than a thickness h of the conductor 30 and the terminal electrode 40. Specifically, the depth d of the recessed portions 23 for terminal electrodes are provided to be smaller than the thickness h of the conductor 30 and the terminal electrode 40 by 0.1 mm. In this case, the depth d of the recessed portions 23 for terminal electrodes are provided in the range of 0 mm < d ≤ 0.2 mm and at the same time the thickness h of the conductor 30 and the terminal electrode 40 is provided in the range of 0.1 mm ≤ h ≤ 0.3 mm.

By adopting the above-described structure, the terminal electrodes 40 enter into the recessed portions 23 for terminal electrodes and thereby the height of the magnetic device 10 can be reduced, so that the magnetic device 10 can be downsized (reduced in height).

Further, as shown in Fig. 1 to Fig. 3, the conductor 30 is provided inside the core member 20. The conductor 30 is extended in a linear manner inside the core member 20. Further, the previously-described magnetic material composing the core member 20 surrounds the circumference of the conductor 30. Further, the terminal electrode 40 protrudes outward from the end surfaces 21b, 21d of the core member 20. Here, in the present mode, the conductor 30 and the terminal electrode 40 are formed by the same thin plate member 50 made of a metal. Based on this, in the present mode, the terminal electrode 40 can be formed easily by bending the thin plate member 50.

Further, in the present mode, the core member 20 is structured to adhere to the conductor 30 directly. Here, as for the relation between the core member 20 and the conductor 30, the description will be given in comparison with an inductance device (see Fig. 9) disclosed in the above-described Patent document 2. As shown in Fig. 9, in the structure disclosed in the above-described Patent document 2, a conductor is inserted into a tubular hole, in which a space exists between the conductor and the tubular hole. However, in the magnetic device 10 according to the present mode, with the adoption of a manufacturing method which will be described later, no space exists between the core member 20 and the conductor 30, in which the conductor 30 is in the state of being surrounded by the core member 20 without the space.

Further, the relation of the sizes of the core member 20 and the conductor 30 of the magnetic device 10 according to the second structural example of the present mode is shown in Fig. 7. As shown in Fig. 7, a size L1 between an upper surface of the conductor 30 and the upper surface 21 a of the core member 20 and a size L2 between a left side surface of the conductor 30 and the side surfaces 21f of the core member 20 in Fig. 7 are provided to be substantially the same. Note that the size between an under surface of the conductor 30 and the under surface 21c of the core member 20 is provided equal to the size L1 and the size between a right side surface of the conductor 30 and the side surfaces 21e of the core member 20 in Fig. 7 is provided equal to the size L2.

As described above, since the size L1 is provided equal to the size L2, when current is applied to the magnetic device 10 (conductor 30), magnetic saturation is caused uniformly in the core member 20. In other words, as compared to the case where the size L1 and the size L2 are provided to have different sizes in which a deviation, for example, one is narrower than the other, is caused, it is possible to improve a DC bias characteristics. Note that the above-described improvement of the DC bias characteristics is contributed largely by a structural aspect of the magnetic device 10. Specifically, since the magnetic device 10 has a simple structure, even when precise press-molding conditions are not set in the press-molding process of the core member 20, a molding density of the core member 20 can be made substantially the same all over the portions of the core member 20. As a result, the magnetic characteristic of the core member 20 becomes uniform all over the portions thereof, allowing the DC bias characteristics to be improved.

Note that the above-described thin plate member 50 is formed by a metal material exhibiting superior conductivity such as copper. Notwithstanding the above, various metals exhibiting superior conductivity other than copper may be used as a material.

Further, the magnetic devices 10 shown in Fig. 1 to Fig. 3 and Fig. 4 to Fig. 7 have only a single conductor 30, allowing increasing the sectional area of the conductor 30 as compared to the case where plural conductors 30 exist inside the core member 20.

Further, as shown in Fig. 3, Fig. 6 and so on, in the state of a finished product after the molding, the terminal electrodes 40 are folded. Here, by folding such as pressing or the like, the terminal electrodes 40 have end surface portions 41 going along the end surfaces 21b, 21d and mounting portions 42 going along the under surface 21c. Of these, the mounting portions 42 are portions to be mounted on a conductive portion (corresponding to an outside conductor) of a not shown mounting substrate while they are in the coated state for example by a solder or the like.

Hereinafter, the description will be given of an example manufacturing method in the case where the magnetic device 10 having the structure as described above is manufactured.

First, before manufacturing the magnetic device 10, in order to form the thin plate member 50 being a base of the conductor 30 and the terminal electrodes 40, punchings are performed to a metal plate. With this punching, the thin plate member 50 having predetermined width and length is formed. Further, independently of the formation of the thin plate member 50, the granulated powders are formed in advance by mixing the magnetic material, the epoxy resin and the organic solvent.

Subsequently, the thin plate member 50 is set inside the metal mold and at the same time a predetermined amount of the granulated powders are set so that the thin plate member 50 is put into a state covered by the granulated powders. In this state, by driving an upper mold and a lower mold in the direction in which they come close to each other, a pressing operation is performed. And, a green compact being a previous state (state before a heating process) of the magnetic device 10 is formed.

Subsequently, the heating process (thermosetting) is performed to the formed green compact. Specifically, the green compact is heated to thereby hot cure the granulated powders. In the thermosetting, it is hot cured for about one and half hours under the temperature of about 180 °C. Backed by this, the resin mixed in the granulated powders (resin binder) melts in which the magnetic powders and the resin binder adhere to each other, so that stable curing is performed.

Subsequently, a plating (for example, a solder plating) is performed to the terminal electrodes 40 to put it into a state easily bondable by the soldering and so forth. Subsequently, of the thin plate member 50, the portions protruded from the end surfaces 21b, 21d are folded toward the under surface 21c side by pressing. With this, the conductor 30 and the terminal electrodes 40 are clearly distinguished in appearance. At the same time, the terminal electrodes 40 are put into a state of having the end surface portions 41 going along the end surfaces 21b, 21d and the mounting portions 42 going along the under surface 21c. In this manner, the magnetic device 10 is completed, and finally, the manufactured magnetic devices 10 are subject to a characteristic evaluation in which such a magnetic device 10 that does not have a predetermined characteristic is removed as an inferior product. Through the above described respective steps, the magnetic device 10 having the predetermined characteristic is manufactured.

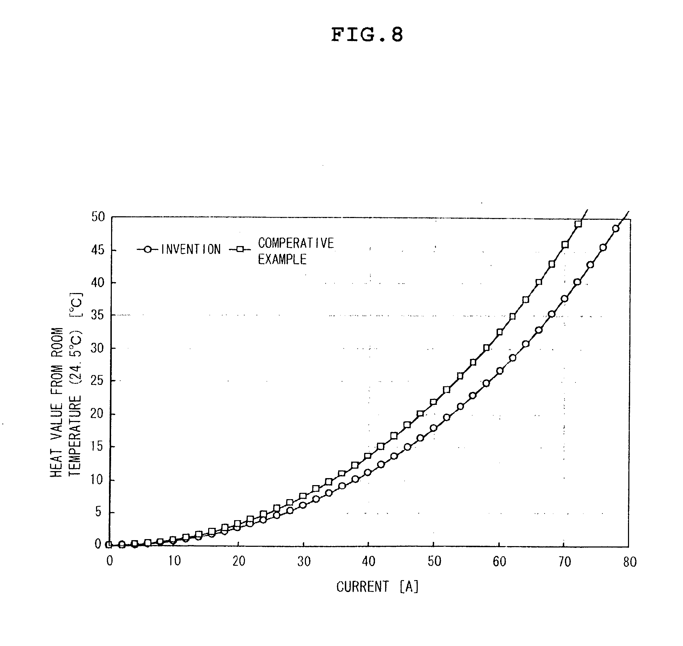

The description will be given of the temperature characteristic of the magnetic device 10 having the above-described structure based on Fig. 8.
Fig. 8 is a view showing a temperature characteristic of the magnetic device 10 (first structural example) according to the present mode at the time of a current application in comparison with that of a comparative one shown in Fig. 9 (conventional example) being a reproduced inductance device disclosed in Patent document 2. As shown in Fig. 8, the temperature increase (heat value) in the magnetic device 10 according to the present mode is suppressed by about 20% when the same current is applied as compared to that of the comparative one. Specifically, it is confirmed for the magnetic device 10 of the present mode that the temperature increase characteristic shows an improvement than the comparative one as a result thereof.

As described above, by adopting the structure in which the core member 20 adheres to the conductor 30 directly, even when the conductor 30 generates heat at the time of the current application, the generated heat is absorbed by the core member 20 immediately. Further, the absorbed heat is thermal diffused by the core member 20 exhibiting much more favorable thermal conductivity than an air to be released further by the outer surface. Therefore, even when, for example, a current of 75A is applied to the magnetic device 10, the temperature increase (heat value) can be suppressed to 40°C or therebelow from a room temperature.

According to the magnetic device 10 of the above structure, the conductor 30 is extended in a linear manner inside the core member 20, in which the conductor 30 does not form a coil inside the core member 20. As the conductor 30 is extended in a linear manner, the L reduction (having lower L value) of the magnetic device 10 can be realized. Backed by this, the magnetic device 10 can be used even in the circuit to which the high frequency is applied such as a power supply system.

Further, in addition to that the L reduction is realized, it becomes possible to also cope with large current. In addition, even when the large current is flowed into the conductor 30, the heat value can be suppressed to be small. In particular, in the magnetic device 10 of the present mode, the structure in which the core member 20 adheres to the conductor 30 directly is adopted. Therefore, even when the conductor 30 generates heat, the generated heat is absorbed by the core member 20 immediately to be released by the outer surface of the core member 20. Therefore, the temperature characteristic of the magnetic device 10 can be made favorable.

Further, the conductor 30 is provided in a liner manner, the manufacturing of the magnetic device 10 is therefore facilitated. In other words, it can be formed easily also by setting the conductor 30 of a linear shape, for example, inside the mold, covering the conductor 30 with the granulated powders thereafter, and performing a press-forming as it is. Thus, when the magnetic device 10 can be formed easily, the production cost of the magnetic device 10 can be reduced as well.

Further, the magnetic device 10 has a simple structure in which the conductor 30 is surrounded by the core member 20 and the terminal electrodes 40 are provided, and that the magnetic device 10 can be manufactured easily as described above. Therefore, the difference between the characteristics of the respective magnetic devices 10 can be reduced. Further, the magnetic device 10 has a simple structure. Therefore, the characteristic design of the magnetic device 10 is facilitated as well. In other words, the characteristic design does not need complicated calculations.

Further, the conductor 30 is formed using the thin plate member 50 of a liner shape. Therefore, the conductor 30 has a structure in which the size in the thickness direction is not large, so that the magnetic device 10 can be downsized easily.

Further, the magnetic device 10 of the second structural example shown in Fig. 4 to Fig. 7 includes the recessed portions 23 for terminal electrodes. Therefore, the terminal electrodes 40 (mounting portions 42) can enter into the recessed portions 23 for terminal electrodes, and thereby the magnetic device 10 can be reduced in height, so that the magnetic device 10 can be downsized (reduced in height). Further, the terminal electrodes 40 (mounting portions 42) are put into the state of slightly protruding from the under surface 21c. Therefore, when the magnetic device 10 is mounted, the terminal electrodes 40 (mounting portions 42) and a cream solder and the like can be jointed surely. Further, when the magnetic device 10 is mounted onto the substrate, the space between the under surface 21c and the mounting substrate can be reduced. With this, mountability of the magnetic device 10 with respect to the mounting substrate can be improved. Further, with the reduction of the space, the magnetic device 10 can be reduced in height after being mounted.

Further in the magnetic device 10 of the second structural example, the size L1 between the upper surface of the conductor 30 and the upper surface 21a of the core member 20 and the size L2 between the left side surface of the conductor 30 and the side surfaces 21f of the core member 20 are provided to be substantially the same. Therefore, when the current is applied to the magnetic device 10 (the conductor 30), the magnetic saturation is caused in the core member 20 uniformly. Backed by this, the deviation in the case where the size L1 and the size L2 are different in size, for example, one is narrower than the other, is eliminated, so that the DC bias characteristics can be improved. Further, since the magnetic device 10 has the simple structure, even when the precise press-molding conditions are not set in the press-molding process of the core member 20, the molding density of the core member 20 can be made substantially the same all over the portions of the core member 20. Backed by this, the magnetic characteristic of the core member 20 becomes uniform all over the portions thereof, allowing the DC bias characteristics to be improved.

Although the magnetic device 10 according to the mode of the present invention has been described in the above, the magnetic device 10 of the present invention is modifiable variously in addition to the above. Hereinafter, the description will be given of the modifications.

In the above-described modes, only the single conductor 30 is provided inside the core member 20. However, the conductor 30 provided inside the core member 20 is not limited to one, and two or more conductors 30 can be provided. Fig. 10 and Fig. 11 show a magnetic device (hereinafter referred to as the "magnetic device 11 ") provided with two pieces of the conductor 30 inside the core member 20. In this structure, the two conductors 30 are arranged to have a certain interval therebetween.

In this manner, when the magnetic device 11 includes plural conductors 30 such as two pieces, the magnetic device 11 can be used as, for example, a multiple inductor, a multiple noise filter, a common mode choke, a transformer and the like with Multiphase support for the power supply circuit driven by high frequency. It should be noted that, when the two or more conductors 30 are provided, the number of the terminal electrodes 40 need to be increased in accordance with the number of the conductors 30.

Note that, Fig. 11 shows a mode where the magnetic device 11 is mounted onto a mounting substrate 60. As shown in Fig. 11, the mounting substrate 60 includes land portions 61 onto which mounting portions 42a, 42d are mounted / jointed, respectively, and a land pattern 62 onto which mounting portions 42b, 42c are mounted / jointed. The land pattern 62 is a conductor portion to be connected to the above-described outside conductor 40 at both the end thereof. This land pattern 62 is to flow current to the adjacent conductors 30. Further, in the present mode, the land pattern 62, the conductors 30 and the outside conductor 40 compose the coil section, allowing a closed magnetic circuit to be formed when the current is conducted.

Further, when the plural conductors 30 are provided, a nonmagnetic layer 22 may be provided between the adjacent conductors 30 as in the magnetic device shown in Fig. 12 (hereinafter the magnetic device is referred to as the "magnetic device 12"). In this case, the nonmagnetic layer 22 is formed by curing a nonmagnetic paste being nonmagnetic as well as nonconductive and mainly composed of, for example, glass (Si), aluminum oxide and the like.

When the nonmagnetic layer 22 is provided as above, magnetic flux flows (short paths of magnetic flux) formed around the respective conductors 30 are broken. Therefore, when the current is conducted, the magnetic flux flows can be unified into one. Accordingly, larger inductance value (L value) can be obtained as compared to the structure having no nonmagnetic layer 22. Further, the DC bias characteristics of the magnetic device 12 can be made favorable, so that the magnetic saturation can be prevented from arising. Note that the magnetic device 12 is suitable for the common mode coil, the inductor, the transformer and the like.

Further, a structure where a gap layer separating the core member 20 into two in the vertical direction thereof is provided instead of the nonmagnetic layer 22 may be adopted. As in the nonmagnetic layer 22, the gap layer is a portion formed by the nonmagnetic member and serving as a magnetic gap. When it is structured in the above described manner, the magnetic device can be improved in the DC bias characteristics as compared to the one without the gap layer. Accordingly, it is possible to increase the area not causing the magnetic saturation can be increased.

Further, in the above-described mode, the conductor 30 and the terminal electrodes 40 are formed by bending the thin plate member 50, respectively, and the magnetic device 10 is mounted on the mounting substrate thereafter. Notwithstanding the above, for example when the mounting substrate is provided with a recessed portion of a size allowing the magnetic device 10 to enter therein, the thin plate member 50 may be mounted as it is without being folded. Note that, in this case, although the terminal electrodes 40 are not folded, a conductive portion contacting the terminal electrodes 40 in the unfolded state needs to be provided in the mounting substrate.

Further, in the magnetic device 10 of the above-described mode, the structure to reduce the L value has been described. However, the magnetic device 10 as described above may be adopted not only in the case to reduce the L value but also in a usage to increase the L value. For instance, then, the magnetic device including the plural conductors 30 inside the core member 20 thereof is used and, at the same time, the land pattern (corresponding to the outside conductor) to connect the adjacent conductors 30 to each other on the different outer surfaces 21 is provided. When it is thus structured, the coil section is put into the state where it is wound several times while the magnetic device is mounted on the mounting substrate. With this, the L value can be increased.

Further, in the above-described mode, the core member 20 has substantially the rectangular parallelepiped shape in appearance. However, the shape of the core member 20 is not limited to the substantially rectangular parallelepiped shape and various shapes may be adopted thereto such as a substantially disk shape and the like.

Further, in the above-described mode, as a conductor, the conductor 30 of a band shape having a rectangular front (or sectional) shape is used. However, the conductor is not limited to the conductor of the band shape having a rectangular front (or sectional) shape, and the conductor having a various front shape or sectional shape including a circle, an oval and so on other than the rectangle is acceptable.

Industrial Availability

The magnetic device according to the present invention can be used in the field of electrical machinery and apparatus.

**Claims**

1. A magnetic device comprising:

   a core member formed by press-molding a mixture mixing magnetic powders containing a metal, and a resin-type binder;
   a conductor provided inside said core member and extended in a linear manner; and
   a terminal electrodes provided on an outer surface of said core member and electrically connected to said conductor as well as a mounting substrate when mounted thereon.

2. The magnetic device according to claim 1, wherein said terminal electrodes are connected to said conductor continuously and folded toward the mounting substrate side.

3. The magnetic device according to claim 2, wherein recessed portions for terminal electrodes are provided in a facing surface of said core member facing to the mounting substrate and the recessed portions for terminal electrodes are recessed deeper than an other portion of the facing surface in accordance with the folded portion of said terminal electrodes.

4. The magnetic device according to claim 1 to 3, wherein an entire outer peripheral surface of said conductor directly adheres to said core member.

5. The magnetic device according to any one of claim 1 to claim 4, wherein a plurality of said conductors are provided inside said core member, and said plurality of conductors are arranged in a state of having a certain interval between their adjacent conductor(s).

6. The magnetic device according to claim 5, wherein said conductors, said terminal electrodes and an outside conductor existing on the mounting substrate form a circuit in which current goes around.

FIG.1

# FIG.2

## FIG.3

# FIG.4

# FIG.5

# FIG.6

# FIG.7

FIG.8

<table>
<tr><td colspan="2" align="center">**INTERNATIONAL SEARCH REPORT**</td><td>International application No.<br>PCT/JP2005/021465</td></tr>
</table>

A. CLASSIFICATION OF SUBJECT MATTER
*H01F27/255*(2006.01), *H01F27/28*(2006.01), *H01F30/00*(2006.01),
*H01F37/00*(2006.01)

According to International Patent Classification (IPC) or to both national classification and IPC

B. FIELDS SEARCHED

Minimum documentation searched (classification system followed by classification symbols)
*H01F27/255*(2006.01), *H01F27/28*(2006.01), *H01F30/00*(2006.01),
*H01F37/00*(2006.01)

Documentation searched other than minimum documentation to the extent that such documents are included in the fields searched
Jitsuyo Shinan Koho          1922-1996   Jitsuyo Shinan Toroku Koho   1996-2006
Kokai Jitsuyo Shinan Koho    1971-2006   Toroku Jitsuyo Shinan Koho   1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 60-34009 A (Tohoku Kinzoku Kogyo Ltd.),<br>21 February, 1985 (21.02.85),<br>Full text; all drawings<br>(Family: none) | 1,2<br>3-6 |
| X | JP 9-270354 A (Matsushita Electric Industrial Co., Ltd.),<br>14 October, 1997 (14.10.97),<br>Full text; all drawings<br>(Family: none) | 1,5 |
| X | JP 6-29125 A (Tokyo Electric Co., Ltd.),<br>04 February, 1994 (04.02.94),<br>Full text; all drawings<br>(Family: none) | 1,2,5,6 |

☒  Further documents are listed in the continuation of Box C.          ☐  See patent family annex.

| | |
|---|---|
| *  Special categories of cited documents:<br>"A"  document defining the general state of the art which is not considered   to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>31 January, 2006 (31.01.06) | Date of mailing of the international search report<br>07 February, 2006 (07.02.06) |
|---|---|
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2005/021465 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2003-309024 A  (TDK Corp.),<br>31 October, 2003 (31.10.03),<br>Par. Nos. [0007], [0008]; Figs. 11, 12<br>(Family: none) | 3,4 |
| Y | JP 11-40426 A  (TDK Corp.),<br>12 February, 1999 (12.02.99),<br>Full text; all drawings<br>(Family: none) | 5 |
| Y | JP 3-22505 A  (Mitsubishi Electric Corp.),<br>30 January, 1991 (30.01.91),<br>Full text; all drawings<br>(Family: none) | 6 |
| P,X | JP 2005-310865 A  (Matsushita Electric<br>Industrial Co., Ltd.),<br>04 November, 2005 (04.11.05),<br>Full text; all drawings<br>(Family: none) | 1,2,5 |
| P,X | JP 2005-310864 A  (Matsushita Electric<br>Industrial Co., Ltd.),<br>04 November, 2005 (04.11.05),<br>Full text; all drawings<br>(Family: none) | 1,2,5 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002 A
- JP 252120 A
- JP 2001 A
- JP 052934 A